Europäisches Patentamt

**European Patent Office**

Office européen des brevets

(11) Veröffentlichungsnummer: **0 251 028 B1**

(12) **EUROPÄISCHE PATENTSCHRIFT**

(45) Veröffentlichungstag der Patentschrift: **23.03.94**

(51) Int. Cl.5: **H04B  1/66**

(21) Anmeldenummer: **87108683.1**

(22) Anmeldetag: **16.06.87**

(54) **Verfahren zur Übertragung eines Audiosignales.**

(30) Priorität: **27.06.86 DE 3621513**

(43) Veröffentlichungstag der Anmeldung:
**07.01.88 Patentblatt  88/01**

(45) Bekanntmachung des Hinweises auf die
Patenterteilung:
**23.03.94 Patentblatt  94/12**

(84) Benannte Vertragsstaaten:
**AT BE CH DE ES FR GB GR IT LI LU NL SE**

(56) Entgegenhaltungen:
**WO-A-86/03873**

**IEEE INTERNATIONAL CONFERENCE ON ACOUSTICS, SPEECH AND SIGNAL PROCESSING, Mai1982, New York, Band 3, Seiten 1696-1699, New York, US; K. ANNAMALAI et al.:"An adaptive transform coding system with short primary blocklengths andfrequency dormain quantization using feedback adaptation"**

**IEEE INTERNATIONAL CONFERENCE ON COMMUNICATIONS '86, Conference Record Band 2,22.-25. Juni 1986, Seiten 1013-1021, IEEE, New York, US; R.L. ZINSER et al.:**

**"Intelligibility tests for digital speech coders with synthetic regenerationduring fades"**

**IEEE TRANSACTIONS ON ACOUSTICS, SPE-ECH AND SIGNAL PROCESSING, Band ASSP-31, Nr.3, Juni 1983, Seiten 664-678, IEEE, New York, US; L.B. ALMEIDA et al.:"Nonstationary spectral modeling of voiced speech"**

(73) Patentinhaber: **TELEFUNKEN Fernseh und Rundfunk GmbH Göttinger Chaussee 76 D-30453 Hannover(DE)**

(72) Erfinder: **Krahé, Detlef, Dipl.-Ing. Kommandantenstrasse 60 D-4100 Duisburg 1(DE)**
Erfinder: **Beckmann, Klaus, Dipl.-Ing. Böllrodt 2A D-4330 Mülheim/Ruhr(DE)**

(74) Vertreter: **Einsel, Robert, Dipl.-Ing. TELEFUNKEN Fernseh und Rundfunk GmbH Göttinger Chaussee 76 D-30453 Hannover (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Übertragung eines Audiosignals gemäß dem Oberbegriff des Anspruchs 1.

Aus der nicht vorveröffenlichten Anmeldung EP-A 0 193 143 ist ein Verfahren zur Übertragung eines Audiosignals bekannt, bei dem das analoge Signal in ein digitales Signal umgewandelt, vor der Übertragung in ein das Kurzzeitspektrum darstellendes Signal umgesetzt wird, wobei das gesamte Frequenzband in mehrere Frequenzgruppen aufgeteilt wird, Signalteile in den Frequenzgruppen auf Basis psychoakustischer Gesetzmäßigkeiten bei der Codierung des zu übertragenden Signals in ihrer Darstellungsgenauigkeit verschieden gewichtet werden, das codierte Signal übertragen, und nach der Übertragung decodiert, rücktransformiert und wieder in ein analoges Signal umgesetzt wird.

In der Anmeldung EP-A 0 193 143 wird ein Verfahren zur Übertragung eines digitalen Audiosignals beschrieben, das mit einer geringeren mittleren Bitrate pro Abtastwert auskommt, ohne daß bei der Wiedergabe die Qualität merkbar beeinflußt wird.

Die Erfindung nach der Anmeldung EP-A 0 193 143 besteht im wesentlichen darin, daß die transformierten Betragswerte in Frequenzgruppen vom jeweiligen Betragsmaximum aus oberhalb einer Schwelle in Wertebereiche aufgeteilt werden und die im gleichen Wertebereich liegenden Betragswerte als gleicher Wert übertragen werden, und daß Betragswerte unterhalb der Schwelle zu Null gesetzt werden.

Der vorliegenden Erfindung liegt die Aufgabe zugrunde, bei einem Verfahren nach dem Oberbegriff des Anspruchs 1 die Wichtung von Amplitudenwerten in Frequenzwerten sowie die Detektion von plötzlichen Schallereignissen zu verbessern und insbesondere psychoakustische Gesichtspunkte beim Übertragungsverfahren besser zu berücksichtigen.

Diese Aufgabe wird durch die im Anspruch 1 oder 2 beschriebene Erfindung gelöst. Vorteilhafte Weiterbildungen der Erfindung sind in den Unteransprüchen beschrieben.

Die Schwelle, unterhalb der in einer Gruppe die Werte zur null gesetzt werden, wird nicht fest bei -30 dB unterhalb des Gruppenmaximums angesetzt, sondern kann adaptiv bis zu -50 dB verschoben werden. Dies ist notwendig, wenn in der Gruppe eine ausgeprägte Spitze im Betragsverlauf vorliegt, da hierbei über diesen großen Dynamikbereich die Spektralwerte eine deutliche lineare Abhängigkeit aufweisen. Werden diese Werte zu Null gesetzt, so ergibt sich aufgrund der Abhängigkeit nach Transformation und Rücktransformation eine modulierende Störung im Zeitsignal, die gut wahrnehmbar ist.

Klassifizierungsmerkmal für das Erkennen einer solchen Situation ist das Verhältnis von Spitzen- zu Mittelwert innerhalb einer Gruppe.

Zur Analyse, ob ein Sprung im Signalverlauf vorliegt, wird in Unterblöcken (z.B. 64 Werte) die Energie des Signals ermittelt, das zuvor über einen Hochpaß geführt wird. Dadurch wird ein eventueller Sprung versteilt und kann besser detektiert werden.

Die daraus abgeleitete Anhebung vor dem Sprung kann wie bisher breitbandig erfolgen, eine bessere Wirkung wird jedoch erzielt, wenn die Anhebung frequenzselektiv ansetzt. Sie kann dann auf die energetisch weniger ausgeprägten Spektralbereiche beschränkt werden, wodurch höhere Anhebungsfaktoren erlaubt sind, ohne dabei den Verlauf des Kurzzeitspektrums wesentlich zu verändern.

Über alle Gruppen hinweg wird eine Hörschwelle gelegt, unterhalb der die Spektralwerte zu Null gesetzt werden. Die Schwelle verläuft dabei in den ersten 23 Gruppen horizontal und steigt innerhalb der letzten 3 Gruppen um ca. 30 dB an. Die Schwelle wird als Ganzes so verschoben, daß im unteren Bereich ein gewisser Abstand (Typ 90 dB) zum maximalen Betragswert gehalten wird. Bei Verschiebungen zu kleineren Werten wird ein Anschlag für die Schwelle definiert, damit nicht absolut sehr kleine Werte berücksichtigt werden.

Mit dieser Schwelle soll zum einen die absolute Hörschwelle, zum anderen gruppenübergreifende Verdeckungseffekte berücksichtigt werden.

Zum besseren Verständnis der Erfindung wird nachstehend ein Ausführungsbeispiel anhand von Zeichnungen näher erläutert.

Es zeigen

Fig. 1    Zeitfenster, in denen ein Sinussignal schwingt,

Fig. 2    Frequenzspektren von einem gefensterten Sinussignal,

Fig. 3    den zeitlichen Ablauf des Verfahrens

Fig. 4    eine Vorverarbeitung des Signales für einen speziellen Signalinhalt,

Fig. 5    ein Blockschaltbild dazu und

Fig. 6    ein Frequenzspektrum mit Schwellen.

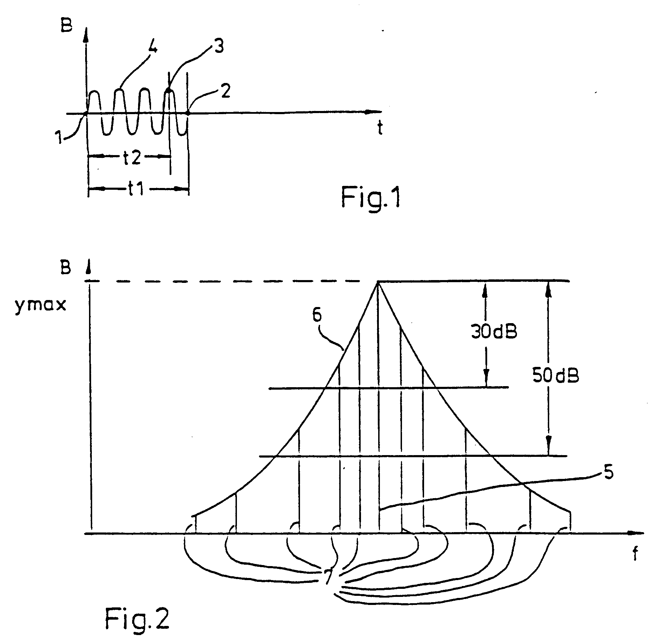

Fig.1 zeigt eine Kurve 4 mit einem sinusförmigen Verlauf. Über diese Kurve 4 sind zwei Zeitfenster t1 und t2 gelegt. Das Zeitfenster t1 beginnt im Nullpunkt 1 des Sinus und endet in einem zweiten Nullpunkt 2 des Sinus. Die Nullpunkte 1 und 2 sind dabei die Schnittpunkte von Sinus und Abzisse, wobei über die Abzisse die Zeit t aufgetragen ist. Das zweite Zeitfenster t2 beginnt im Nullpunkt des Sinus, endet aber außerhalb eines Nullpunktes im Punkt 3.

Bei der Transformation von Zeitsignalen in ein das Kurzzeitspektrum darstellendes Signal werden verschiedene Kurven in dem Frequenzspektrum erzielt. Fig. 2 zeigt das Frequenzspektrum, das zu den beiden gefensterten Sinussignalen gehört. Für das Zeitfenster t1 ergibt sich nur eine Frequenzlinie 5. Für das Sinussignal, das über das Zeitfenster t2 gefenstert wird, ergibt sich ein Frequenzspektrum mit dem Kurvenverlauf 6, das ein Maximum an der Frequenzlinie 5 und eine abfallende Kurvenform mit mehreren Frequenzlinien 7 aufweist. In einer Frequenzgruppe können bei der Begrenzung und Übertragung von Werten, die nur innerhalb eines Dynamikbereiches von 30dB unterhalb des Maximums ymax liegen, durch die lineare Abhängigkeit der Spektralwerte modulierenden Störungen auftreten, die gut wahrnehmbar sind. Deshalb wird der Dynamikbereich auf bis zu 50 dB adaptiv vergrößert. Das Klassifizierungsmerkmal für das Erkennen einer solchen Situation ist das Verhältnis von Spitzen- zum quadratischen Mittelwert innerhalb einer Frequenzgruppe. Dabei wird die Differenz von Spitzen- zum Mittelwert in einer Frequenzgruppe gebildet und die Differenz mit einem Faktor, in diesem Fall 3, multipliziert. Das Produkt ergibt den neuen Dynamikbereich. Liegt ein Spitzenwert bei 60 dB und der zugehörige Mittelwert bei 45dB, so ist die Differenz 15dB. Die Differenz 15dB wird mit dem Faktor 3 multipliziert, das ergibt einen neuen Dynamikbereich von 45dB, also eine adaptive Anpassung zwischen -30 und minus 50dB. Wird parallel zur Festlegung der Schwelle, die die Gruppendynamik festlegt, festgestellt, daß die Differenz zwischen maximalem und minimalem Betragswert in einer Gruppe kleiner als 30dB ist, so wird der darzustellende Dynamikbereich gleich dieser Differenz gesetzt.

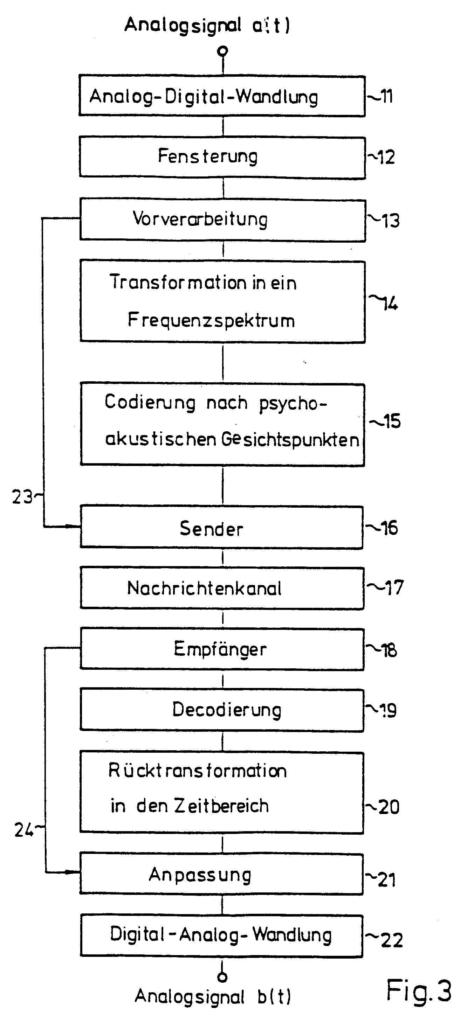

In Fig. 3 wird das Analog-Signal a(t), das ein Audiosignal wie z.B. Sprache oder Musik darstellt, in dem Analog/Digital-Wandler 11 in ein entsprechendes digitales Audiosignal umgewandelt. In der Stufe 12 erfolgt durch zeitlich aufeinanderfolgende und überlappende Zeitfenster eine sogenannte Fensterung dieses Signales. Das Signal wird dabei in zeitlich aufeinanderfolgende Blöcke mit je einer Dauer von ca. 20ms, insbesondere 23ms, aufgeteilt, derart, daß jeweils das Signal eines Blockes für sich getrennt weiter bearbeitet werden kann. In der Stufe 13 erfolgt eine Vorverarbeitung des Signales, deren Bedeutung später erläutert wird. In der Stufe 14 wird jeweils das digitale Signal eines Zeitfensters oder eines Blockes durch eine Transformation in ein Frequenz-Spektrum umgesetzt. Am Ausgang der Stufe 14 steht also während der zeitlich aufeinanderfolgenden Blöcke jeweils ein Signal, das für die Dauer eines Zeitfensters oder Blockes die Spektralkomponenten des Signals über das gesamte Frequenzband darstellt. Die Stufe 14 bewirkt also die Umsetzung des Signals vom Zeitbereich in das das Spektrum darstellende Signal im Frequenzbereich.

Das Signal von der Stufe 14 gelangt zum Coder 15. Hier erfolgt eine Codierung nach psychoakustischen Gesichtspunkten. Das bedeutet, daß Spektralkomponenten, die bei der Wiedergabe insbesondere aufgrund von Verdeckungseffekten ohnehin nicht wahrgenommen werden, bei der Codierung geringer gewichtet oder weggelassen werden. Eine derartige Verarbeitung des Kurzzeit-Spektrums ist möglich z.B. mit Hilfe eines Rechners.

Das derart codierte Signal gelangt über den Sender 16 zum Nachrichtenkanal 17. Durch die erzielte Verringerung der mittleren Bitrate kann dieser Nachrichtenkanal entsprechend schmalbandig bemessen werden. Auf den Nachrichtenkanal 17 folgt der Empfänger 18, der im wesentlichen die zum Sender inversen Funktionen ausführt. Das Signal gelangt zunächst zu einem Decoder 19, der entsprechend dem Coder 15 die Decodierung bewirkt. In der Stufe 20 wird das so gewonnen, das Spektrum-darstellende Signal im Frequenzbereich wieder in ein digitales Signal im Zeitbereich umgesetzt. In der Stufe 21 wird das Signal wieder zu einem einheitlichen kontinuierlichen digitalen Signal zusammengesetzt und die Vorverarbeitung der Stufe 13 berücksichtigt. Dann wird das Signal dem Digital/Analog-Wandler 22 zugeführt. Der Wandler 22 liefert wieder das Analogsignal b(t). Dieses Signal ist mit dem Signal a(t) nicht identisch, weil im Coder 15 bei der Codierung Spektral-Komponenten unterschiedlich gewichtet oder unterdrückt wurden. Der Unterschied zwischen den Analogsignalen b(t) und a(t) ist aber so, daß er bei der Wiedergabe vom Hörer nicht bemerkt wird. In dem Signal wird also lediglich Irrelevanz, für den Hörer unhörbare Information, beseitigt, um die notwendige Bitrate bei der Übertragung über den Nachrichtenkanal 17 zu verringern, speziell wird der Entscheidungsgehalt verringert. Auf dem Signalpfad 23 teilt die Vorverarbeitungsstufe 13 dem Sender 16 mit, ob eine Vorverarbeitung stattgefunden hat. Ist das der Fall, so wird eine Nebeninformation in das codierte Signal eingefügt bzw. gemultiplext, das der Empfänger 18 erkennt und der Anpassungsstufe 21 über den Signalpfad 24 mitteilt. Vor dem Analog-Digital Wandler 11 ist ein Tiefpaß zur Erfüllung des Abtasttheorems eingefügt. Nach dem Digital-Analog Wandler 22 ist ein zweiter Tiefpaß als Rekonstruktionstiefpaß angeordnet.

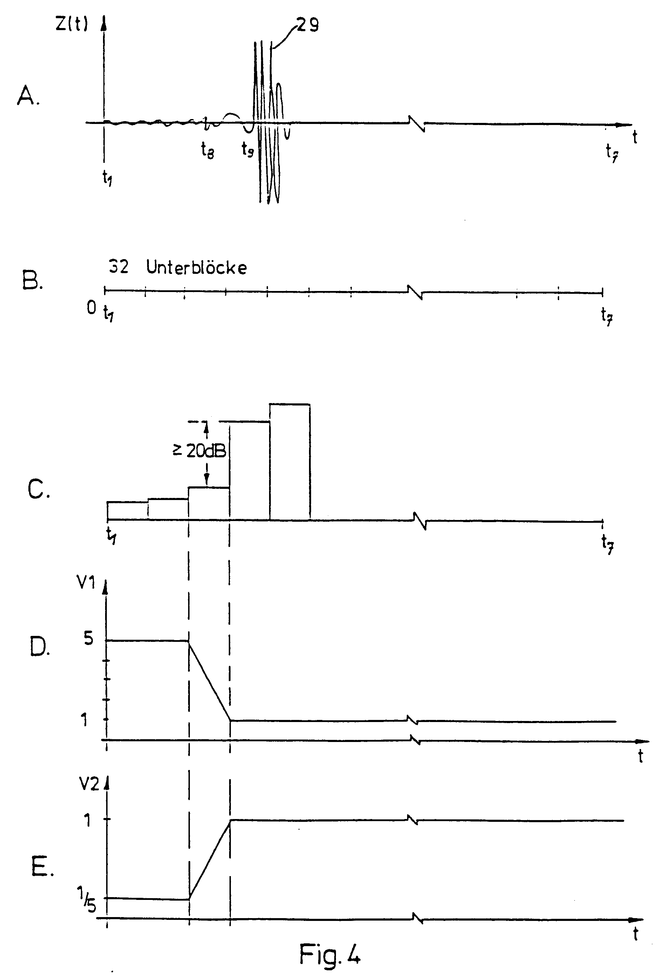

Fig. 4 zeigt die Vorverarbeitung eines plötzlichen Schallereignisses 29, das innerhalb eines Zeitfensters t1 - t7 im Zeitpunkt t9 auftritt. Ein solches Schallereignis kann z.B. ein Triangelanschlag sein. Die beschriebene Vorverarbeitung erfolgt in Fig. 3 in der Stufe 13. Dem Schallereignis 29 geht noch ein Vorschwinger zwischen t8 und t9 voraus, der aber durch eine Vorverdeckung nicht hörbar ist. Bei der Umwandlung in das Frequenzspektrum in der Stufe 14 in Fig. 3 entsteht jeweils ein Signal im Frequenzbereich, das die Spektralverteilung im Fenster t1 - t7 angibt. Da bei diesem Signal die Zuordnung von Spektrallinien zu einzelnen Zeitpunkten innerhalb eines Zeitfensters nicht mehr gegeben ist, würde das Ereignis 29 über das gesamte Zeitfenster t1 - t7 gemittelt, also quasi verschmiert. Dadurch kann eine hörbare Verfälschung eintreten.

Zur Vermeidung dieses noch denkbaren Fehlers ist ein Zeitfenster t1 - t7 oder auch Block in 32 Unterblöcke aufgeteilt. Die Amplituden der einzelnen Unterblöcke werden ermittelt. Sobald ein Amplitudensprung zwischen zwei Unterblöcken von mehr als einem vorgegebenen Limit auftritt, in Fig. 4 bedingt durch das Ereignis 29, wird eine zusätzliche Maßnahme ausgelöst. Das vorgegebene Limit liegt in der Größenordnung von 20dB. Die Maßnahme besteht darin, daß das Signal vor dem Amplitudensprung durch ein Kompanderverfahren auf der Sendeseite in der Amplitude angehoben und auf der Empfängerseite wieder entsprechend abgesenkt wird. Dadurch werden die genannten Fehler durch die Verschmierung des kurzzeitigen Ereignisses über das ganze Zeitfenster verringert. Die Figuren 4D und 4E zeigen die Wirkungsweise eines Kompandersystems. Vor einem Signalsprung wird in der Vorverarbeitung in einem Expander ein Signal mit dem einen Verstärkungfaktor V1, in diesem Fall 5, vorstärkt. Auf der Empfängerseite wird diese in einem Kompressor in der Anpassung 21 mit einem zweiten Verstärkungsfaktor V2, in diesem Fall 1/5, rückgängig gemacht. Die Gesamtverstärkung für das Signal beträgt die gesamte Zeit "1".

$$V\ Ges = V1 * V2 = 1$$

Nach einem Signalsprung betragen die Verstärkungsfaktoren bis zum nächsten Sprung sowohl im Expander als auch im Kompressor den Wert 1. In den Übergängen zwischen den Verstärkungsfaktoren 1 und 5 liegt ein geradlinieger oder gekrümmter Verlauf über einen Zeitraum zwischen einem halben oder einen gesamten Unterblock, vorzugsweise jedoch über die Zeitdauer eines Unterblockes. Ziel ist die Ausnutzung des Vorverdeckkungseffektes des Ohres (unter 1ms).

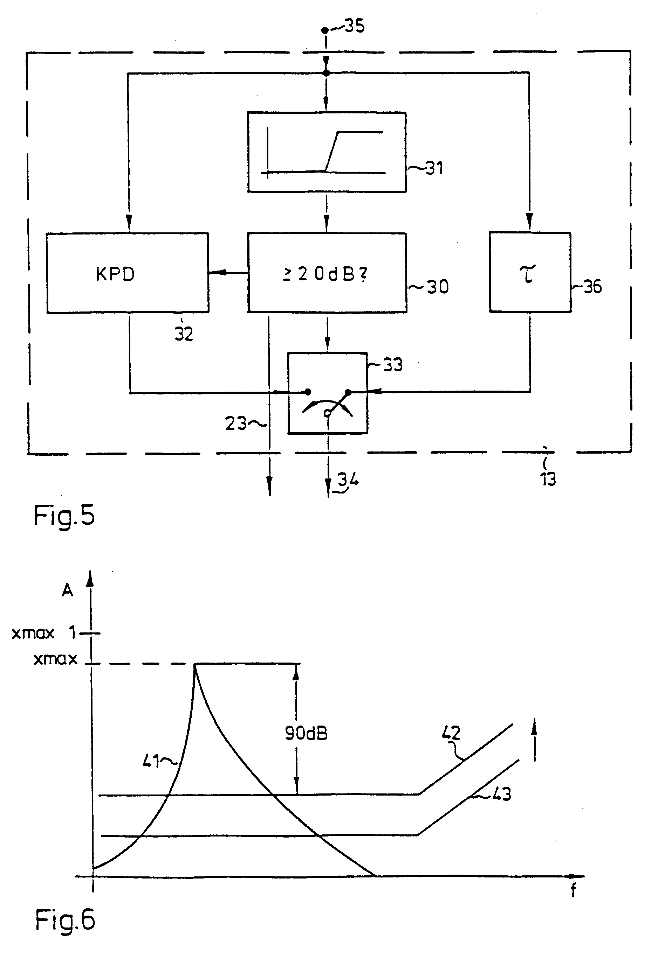

Die Vorverarbeitung 13 wird in der Fig. 5 gezeigt. Der Block 30 prüft, ob ein Signal zwischen zwei der 32 Unterblöcken um ein vorgegebenes Limit ansteigt. So lange der Anstieg zwischen zwei Blöcken unterhalb des vorgegebenen Limits (20dB) liegt, wird das Signal vom Eingang 35 direkt über eine Zeitverzögerung 36 und den Umschalter 33 auf den Ausgang 34 geschaltet. Liegt ein Signalsprung zwischen zwei Unterblöcken um 20dB vor, so wird das Signal vom Eingang 35 über einen Expander 32 und über den Umschalter 33 auf den Ausgang 34 geschaltet. Der Hochpaß 31 versteilt einen eventuellen Sprung im Signal, damit der Sprung von dem Block 30 besser detektiert wird. Dann wird das Signal vor dem Amplitudensprung durch den Expander 32 auf der Senderseite in der Amplitude angehoben und auf der Empfängerseite entsprechend wieder abgesenkt. Dadurch werden Fehler durch eine Verschmierung des kurzzeitigen Ereignisses über das ganze Zeitfenster verringert. Der Prüfblock 30 arbeitet fortwährend, auch während das Signal vom Eingang 35 direkt über den Umschalter 33 auf den Ausgang 34 geschaltet ist. Die Zeitverzögerung 36 gleicht Zeitunterschiede aus, die der Expander 32 und der Prüfblock 30 verursachen. Der Prüfblock 30 teilt dem Expander 32 den Zeitpunkt eines Sprunges bzw. das Überschreiten eines Limits mit. Diese Mitteilung ist eine Information über die Nummer des Unterblockes. Der Expander 32 berechnet selbstständig einen geeigneten Verstärkungsfaktor.

Fig. 6 zeigt ein Koordinatensystem, auf dessen Abzisse über eine Frequenz f der Kurvenverlauf 41 eines Frequenzspektrums aufgetragen ist. Der Kurvenverlauf 41 weist ein Maximum xmax auf. Ein absolutes Maximum xmax1 entspricht einem Pegel A von null Dezibel. In einem Rechner entspricht diesen null Dezibel eine absolute Größe von 2 Exponent (exp) 15, die zusätzlich noch mit einem Verstärkungsfaktor von 1024 verstärkt wird. Dann wird insgesamt mit einer absoluten Größe von 2 exp 25 gerechnet. Die Größen entsprechen einer elektrischen Spannung. Über den gesamten Frequenzverlauf wird eine Hörschwelle 42 gelegt, unterhalb der die Spektralwerte zu null gesetzt werden, d.h. nicht berücksichtigt werden. Diese Schwelle 42 verläuft in den ersten 23 Frequenzgruppen parallel zur Abzisse und steigt innerhalb der letzten 3 Gruppen um ca. 30dB an, wobei der Anstieg ab 10kHz erfolgt. Die Schwelle 42 weist gegenüber dem (veränderbaren) Maximum xmax vor einem ersten Anstiegspunkt, im folgenden Knickpunkt genannt, immer einen Abstand von 90dB auf. D.h. diese Schwelle wird immer in Abhängigkeit des Maximums xmax gelegt. Die Schwelle 42 kann allerdings nicht unter einen Minimalwert 43, im folgenden Anschlag genannt, absinken. Dieser Anschlag 43 liegt bei -128dB zum absoluten Maximum. Vorteilhaft wird der erste Knickpunkt bei 10kHz und ein zweiter Knickpunkt bei 12kHz gelegt. Zwischen diesen beiden Knickpunkten steigt die Schwelle 42 zunächst um 10dB an. Ab dem zweiten Knickpunkt, also in dem Bereich zwischen 12 und 22 kHz weist die Schwelle 42 eine Steigung von 90 dB auf. Die Frequenzgruppen und eine Einteilung eines Frequenzspektrums ist erläutert z.B. in "Psychoakustik" von E. Zwicker, erschienen im Springer Verlag, Berlin Heidelberg New York 1982.

**Patentansprüche**

1. Verfahren zur Übertragung eines Audiosignals, bei dem das analoge Signal in ein digitales Signal umgewandelt, digital übertragen und wieder in analoges Signal umgesetzt wird, wobei das Audiosignal vor der Übertragung in ein das Kurzzeitspektrum darstellendes Signal umgesetzt wird, wobei das gesamte Frequenzband in mehrere Frequenzgruppen aufteilt wird, Signalteile in den Frequenzgruppen auf Basis psychoakustischer Gesetzmäßigkeiten bei der Codierung des zu übertragenden Signals in ihrer Darstellungsgenauigkeit verschieden gewichtet werden, das codierte Signal übertragen, und nach der Übertragung decodiert, rücktransformiert und wieder in ein analoges Signal umgesetzt wird, wobei einer Frequenzgruppe eine Schwelle zugeordnet ist und Betragswerte unterhalb der Schwelle zu Null gesetzt werden, **dadurch gekennzeichnet**, daß die Schwellen unter Berücksichtigung einer absoluten Hörschwelle und gruppenübergreifender Verdeckungseffekte verschoben werden und/oder eine frequenzselektive Anhebung der Betragswerte erfolgt.

2. Verfahren zur Übertragung eines Audiosignals, bei dem das analoge Signal in ein digitales Signal umgewandelt, digital übertragen und wieder in analoges Signal umgesetzt wird, wobei das Audiosignal vor der Übertragung in ein das Kurzzeitspektrum darstellendes Signal umgesetzt wird, wobei das gesamte Frequenzband in mehrere Frequenzgruppen aufteilt wird, Signalteile in den Frequenzgruppen auf Basis psychoakustischer Gesetzmäßigkeiten bei bei der Codierung des zu übertragenden Signals in ihrer Darstellungsgenauigkeit verschieden gewichtet werden, das codierte Signal übertragen, und nach der Übertragung decodiert, rücktransformiert und wieder in ein analoges Signal umgesetzt wird, wobei einer Frequenzgruppe eine Schwelle zugeordnet ist und Betragswerte unterhalb der Schwelle zu Null gesetzt werden, **dadurch gekennzeichnet**, daß die Schwellen abhängig vom Verhältnis von Spitzen- zu Mittelwert innerhalb einer Frequenzgruppe verschoben werden und/oder eine frequenzselektive Anhebung der Betragswerte erfolgt.

3. Verfahren nach Anspruch 1 oder 2, **dadurch gekennzeichnet**, daß die Schwelle, unterhalb der in einer Frequenzgruppe die Werte zu Null gesetzt werden, adaptiv verschoben wird (Fig.2).

4. Verfahren nach einem der vorhergehenden Ansprüche , **dadurch gekennzeichnet**, daß die Schwelle zwischen -30 und -50dB verschoben wird.

5. Verfahren nach Anspruch 1 oder 2, **dadurch gekennzeichnet**, daß ein Signal in der Vorverarbeitung 13 vor dem Prüfblock (30) über einen Hochpaß (31) geführt wird.

6. Verfahren nach Anspruch 1 oder 2, **dadurch gekennzeichnet**, daß über alle Frequenzgruppen hinweg eine Hörschwelle (42) gelegt wird.

7. Verfahren nach Anspruch 6, **dadurch gekennzeichnet**, daß die Hörschwelle (42) einen vorgegebenen Abstand zu einem Maximum (xmax) einnimmt.

8. Verfahren nach Anspruch 7, **dadurch gekennzeichnet**, daß die Hörschwelle (42) nur bis zu einem Anschlag (43) verschiebbar ist.

9. Verfahren nach Anspruch 8, **dadurch gekennzeichnet**, daß der Anschlag (43) einen Abstand von etwa -128 dB von einem absoluten Maximum (xmax1) aufweist.

10. Empfänger zum Empfang eines Audiosignals, welches unter Verwendung eines Analog/Digital-Wandlers (11) in ein digitales Signal gewandelt ist, welches digital übertragen und nach dem Empfang unter Verwendung eines Digital/Analog-Wandlers (22) wieder in ein analoges Signal umgesetzt ist, wobei das gesamte Frequenzband des Audiosignals in mehrere Frequenzgruppen aufgeteilt ist, Signalteile in den Frequenzgruppen unter Verwendung eines Coders (15) auf Basis phychoakustischer Gesetzmäßigkeiten bei der Codierung des zu übertragenden Signals in ihrer Darstellungsgenauigkeit verschieden gewichtet sind, wobei einer Frequenzgruppe eine Schwelle zugeordnet ist und Betragswerte unterhalb der Schwelle zu null gesetzt sind, wobei im Empfänger (18) ein Decoder (19) enthalten ist, der eine einem sendeseitigen Coder (15) entsprechende Decodierung bewirkt und dem D/A-Wandler (22) das decodierte Signal zuführt, **dadurch gekennzeichnet**, daß im Coder (15) unter Berücksichtigung einer absoluten Hörschwelle und gruppenübergreifender Verdeckungseffekte die Schwelle verschiebbar ist und/oder eine frequenzselektive Anhebung der Betragswerte erfolgt und Irrelevanzanteile des Audiosignals (b(t)) vollständig oder teilweise beseitigt oder stark verringert sind.

**11.** Empfänger nach Anspruch 10, **dadurch gekennzeichnet**, daß der Empfänger (18) erkennt, ob eine Nebeninformation ,die mitteilt, ob eine Vorverarbeitung stattgefunden hat, in das kodierte Signal eingefügt bzw. gemultiplext ist und daß in einer Anpassungsstufe (21) das übertragene Ausdiosignal zu einem einheitlichen digitalen Signal zusammengesetzt wird und daß die Anpassungsstufe (21) die coderseitige Vorverarbeitung des Audiosignals berücksichtigt.

## Claims

**1.** A method of transmitting an audio signal, wherein the analog signal is converted to a digital signal, transmitted digitally and converted back to an analog signal, wherein the audio signal is converted into a signal representing the short time spectrum before being transmitted, wherein the whole frequency band is divided into a plurality of frequency groups, parts of signals in the frequency groups are given different weighting in their representational accuracy in the coding of the signal to be transmitted, based on psycho acoustic laws, wherein the coded signal is transmitted and after transmission is decoded, transformed back and converted back to an analog signal, and wherein a threshold is allocated to a frequency group and amount values below the threshold are set to zero, characterised in that the thresholds are shifted to allow for an absolute hearing threshold and masking effects covering more than one group and/or there is frequency-selective raising of the amount values.

**2.** A method of transmitting an audio signal, wherein the analog signal is converted to a digital signal, transmitted digitally and converted back to an analog signal, wherein the audio signal is converted before transmission into a signal representing the short time spectrum before being transmitted, wherein the whole frequency band is divided into a plurality of frequency groups, parts of signals in the frequency groups are given different weighting in their representational accuracy in the coding of the signal to be transmitted, based on psycho acoustic laws, wherein the coded signal is transmitted and after transmission is decoded, transformed back and converted back to an analog signal, and wherein a threshold is allocated to a frequency group and amount values below the threshold are set to zero, characterised in that the thresholds are shifted dependent on the ratio of the peak value to the mean value within a frequency group and/or there is frequency-selective raising of the amount values.

**3.** The method of claim 1 or 2 characterised in that the threshold below which the values are set to zero in a frequency group is shifted adaptively (figure 2).

**4.** The method of any of the preceding claims, characterised in that the threshold is shifted between -30 and -50 dB.

**5.** The method of claim 1 or 2, characterised in that a signal in preprocessing (13) is taken through a high pass filter (31) before the checking block (30).

**6.** The method of claim 1 or 2, characterised in that a hearing threshold (42) is placed across all the frequency groups.

**7.** The method of claim 6, characterised in that the hearing threshold (42) assumes a predetermined distance from a maximum (xmax).

**8.** The method of claim 7, characterised in that the hearing threshold (42) can be shifted only as far as a stop (43).

**9.** The method of claim 8, characterised in that the stop (43) is at about -128 dB from an absolute maximum (xmax1).

**10.** A receiver to receive an audio signal which is converted to a digital signal using an analog/digital converter (11), which signal is transmitted digitally and after being received is converted back to an analog signal using a digital/analog converter (22), wherein the whole frequency band of the audio signal is divided into a plurality of frequency groups, and parts of signals in the frequency groups are given different weighting in their representational accuracy in the coding of the signal to be transmitted, using a coder (15) based on psycho acoustic laws, wherein a threshold is allocated to a frequency group and amount values below the threshold are set to zero, and wherein a decoder (19) contained in the receiver (18) effects decoding corresponding to a coder (15) at the transmission side, and the decoded signal is supplied to the D/A converter (22), characterised in that the threshold in the coder (15) can be shifted to allow for an absolute hearing threshold and masking effects covering more than one group and/or there is frequency-selective raising of the amount values, and irrelevant parts of the audio signal (h(t) )are completely or partially removed or greatly reduced.

11. The receiver of claim 10, characterised in that the receiver (18) recognises whether an additional piece of information, reporting whether preprocessing has taken place, has been inserted or multiplexed into the coded signal, that the audio signal transmitted is constituted into a uniform digital signal in an adaptation stage (21), and that the adaptation stage (21) allows for the preprocessing of the audio signal by the coder.

**Revendications**

1. Procédé pour la transmission d'un signal son dans lequel le signal analogique est transformé en un signal numérique, est transmis de manière numérique et est retransformé en un signal analogique, le signal son étant transformé, avant la transmission, en un signal qui représente le spectre instantané, l'ensemble de la bande de fréquence étant réparti en plusieurs groupes de fréquences, des fractions de signal dans les groupes de fréquences étant pondérées différemment dans leur exactitude de représentation sur la base de lois psychoacoustiques lors du codage du signal à transmettre, le signal codé étant transmis et, après transmission, décodé, subissant une transformation inverse et étant retransformé en un signal analogique, un seuil étant affecté à un groupe de fréquences et des valeurs absolues au-dessous du seuil étant mises à zéro, **caractérisé en ce** que les seuils sont décalés en tenant compte d'un seuil audible absolu et d'effets d'occultation recouvrant tous les groupes et/ou une augmentation sélective en fréquence des valeurs absolues est effectuée.

2. Procédé pour la transmission d'un signal son dans lequel le signal analogique est transformé en un signal numérique, est transmis de manière numérique et est retransformé en un signal analogique, le signal son étant transformé, avant la transmission, en un signal qui représente le spectre instantané, l'ensemble de la bande de fréquence étant réparti en plusieurs groupes de fréquences, des fractions de signal dans les groupes de fréquences étant pondérées différemment dans leur exactitude de représentation sur la base de lois psychoacoustiques lors du codage du signal à transmettre, le signal codé étant transmis et, après transmission, décodé, subissant une transformation inverse et étant retransformé en un signal analogique, un seuil étant affecté à un groupe de fréquences et des valeurs absolues au-dessous du seuil étant mises à zéro, **caractérisé en ce** que les seuils sont décalés à l'intérieur d'un groupe de fréquences en fonction du rapport de la valeur de crête et de la moyenne et/ou qu'une augmentation sélective en fréquence des valeurs absolues est effectuée.

3. Procédé selon la revendication 1 ou 2, **caractérisé en ce** que le seuil, au-dessous duquel les valeurs sont mises à zéro dans un groupe de fréquences, est décalé de manière adaptative (figure 2).

4. Procédé selon l'une des revendications précédentes, **caractérisé en ce** que le seuil est décalé entre -30 et -50 dB.

5. Procédé selon la revendication 1 ou 2, **caractérisé en ce** qu'un signal dans le traitement préliminaire 13 est guidé avant le bloc de contrôle (30) par un filtre passe-haut (31).

6. Procédé selon la revendication 1 ou 2, **caractérisé en ce** qu'un seuil audible (42) est mis par dessus tous les groupes de fréquences.

7. Procédé selon la revendication 6, **caractérisé en ce** que le seuil audible (42) a un écart prédéterminé par rapport au maximum (xmax).

8. Procédé selon la revendication 7, **caractérisé en ce** que le seuil audible (42) ne peut être décalé que jusqu'à une butée (43).

9. Procédé selon la revendication 8, **caractérisé en ce** que la butée (43) présente un écart d'environ -128 dB par rapport au maximum absolu (xmax1).

10. Récepteur pour la réception d'un signal son qui est transformé en utilisant un convertisseur analogique/numérique (11) en un signal numérique qui est transmis de manière numérique et qui, après réception, est retransformé en signal analogique en utilisant un convertiseur numérique/analogique (22), l'ensemble de la bande de fréquence du signal son étant réparti en plusieurs groupes de fréquences, des fractions de signal dans les groupes de fréquences étant pondérées différemment dans leur exactitude de représentation en utilisant un codeur (15) sur la base de lois psychoacoustiques lors du codage du signal à transmettre, un seuil étant affecté à un groupe de fréquences et des valeurs absolues au-dessous du seuil étant mises à zéro, un décodeur (19) qui provoque un décodage qui correspond à un codeur côté émetteur (15) étant contenu dans le récepteur (18) et le signal décodé étant amené au convertisseur numérique/analogique (22), **caractérisé en ce** que le seuil peut être décalé dans le codeur (15) en tenant compte d'un seuil audible absolu et d'effets d'occultation qui recouvrent tous les groupes et/ou une augmentation sélective en fréquence des valeurs absolues étant effectuée et des fractions insignifiantes du signal son (b(t)) étant complètement ou partiellement éliminées ou fortement diminuées.

11. Récepteur selon la revendication 10, **caractérisé en ce** que le récepteur (18) reconnaît si une information auxilaire, qui indique qu'un traitement préliminaire a eu lieu, est insérée et/ou multiplexée dans le signal codé et que le signal son transmis est composé dans un étage d'adaptation (21) en un signal numérique uniforme et que l'étage d'adaptation (21) tient compte du traitement préliminaire côté codeur du signal son.

EP 0 251 028 B1

Fig.1

Fig.2

Analogsignal a(t)

Analog-Digital-Wandlung ~11

Fensterung ~12

Vorverarbeitung ~13

Transformation in ein
Frequenzspektrum ~14

Codierung nach psychoakustischen Gesichtspunkten ~15

23~

Sender ~16

Nachrichtenkanal ~17

Empfänger ~18

Decodierung ~19

Rücktransformation
in den Zeitbereich ~20

24~

Anpassung ~21

Digital-Analog-Wandlung ~22

Analogsignal b(t)

Fig.3

Fig.4

Fig.5

Fig.6